(19) **Europäisches Patentamt**
**European Patent Office**
**Office européen des brevets**

(11) **EP 4 679 731 A1**

(12) **EUROPÄISCHE PATENTANMELDUNG**

(43) Veröffentlichungstag:
**14.01.2026 Patentblatt 2026/03**

(21) Anmeldenummer: **24188379.2**

(22) Anmeldetag: **12.07.2024**

(51) Internationale Patentklassifikation (IPC):
***H04B 10/2575*** (2013.01)  ***H03C 3/40*** (2006.01)
***H03D 7/00*** (2006.01)  ***H04L 27/227*** (2006.01)

(52) Gemeinsame Patentklassifikation (CPC):
**H04B 10/2575; H03C 3/40; H03D 7/165;**
H04L 27/2273

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **Universität Kassel**
**34125 Kassel (DE)**

(72) Erfinder:
• **WEBER, Clemens**
**34587 Felsberg (DE)**
• **SANDHAGEN, Carl**
**34125 Kassel (DE)**
• **BANGERT, Axel**
**34130 Kassel (DE)**

(74) Vertreter: **Kleine, Hubertus et al**
**Loesenbeck - Specht - Dantz**
**Patent- und Rechtsanwälte**
**Am Zwinger 2**
**33602 Bielefeld (DE)**

(54) **VERFAHREN UND ANORDNUNG ZUR ÜBERTRAGUNG VON ZWEI BINÄREN BASISBANDSIGNALEN ÜBER EINE GEMEINSAME DIGITALE ÜBERTRAGUNGSSTRECKE**

(57)   Die Erfindung betrifft ein Verfahren und eine Anordnung zur Übertragung von zwei binären Basisbandsignalen (I, Q) über eine gemeinsame digitale Übertragungsstrecke bei einer gegenüber einer Grenzfrequenz der Basisbandsignale erhöhten Trägerfrequenz ($f_c$). Das Verfahren zeichnet sich dadurch aus, dass aus den binären Basisbandsignalen (I, Q) ein Summensignal ($\tilde{Q}$) und Differenzsignal ($\tilde{I}$) gebildet werden, wobei das Summensignal ($\tilde{Q}$) und das Differenzsignal ($\tilde{I}$) Eingängen eines Quadraturmischers (122) zugeführt werden, sie durch den Quadraturmischer (122) zusammengeführt werden und mithilfe eines Trägerfrequenzsignals mit der Trägerfrequenz ($f_c$) zu einem Signal ($M_{IQ}$) aufwärts gewandelt werden, wobei das aufwärts gewandelte Signal ($M_{IQ}$) über die digitale Übertragungsstrecke übertragen wird. Die Anordnung zeichnet sich durch eine Vorverarbeitungsstufe (121) aus, um aus den binären Basisbandsignalen (I, Q) ein Summensignal ($\tilde{Q}$) und Differenzsignal ($\tilde{I}$) zu bilden, und einem Quadraturmischers (122), um das Summensignal ($\tilde{Q}$) und das Differenzsignal ($\tilde{I}$) zusammenzuführen und mithilfe eines Trägerfrequenzsignals mit der Trägerfrequenz ($f_c$) zu einem Signal ($M_{IQ}$) aufwärts zu wandeln und das aufwärts gewandelte Signal ($M_{IQ}$) über die digitale Übertragungsstrecke zu übertragen.

Fig. 3

**Beschreibung**

Die Erfindung betrifft ein Verfahren und eine Anordnung zur Übertragung von zwei binären Basisbandsignalen über eine gemeinsame digitale Übertragungsstrecke bei einer gegenüber einer Grenzfrequenz der Basisbandsignale erhöhten Trägerfrequenz.

In aktuellen Mobilfunknetzen ist das abgedeckte Gebiet in Funkzellen unterteilt, die in der Regel nur eine Basisstation aufweisen, von der aus die Kommunikation mit allen mobilen Endgeräten innerhalb der Funkzelle durchgeführt wird. Die Basisstation nutzt zur Kommunikation mit den Mobilgeräten innerhalb der Funkzelle eine oder mehrere Antennen, die unmittelbar an der Basisstation angeordnet sind, beispielsweise an Antennenmasten.

Neben einem solchen üblichen zellularen Aufbau eines Mobilfunknetzes ist als Alternative ein funkzellenfreies Mobilfunknetz denkbar, bei dem mindestens eine zentrale Recheneinheit in dem abgedeckten Gebiet vorhanden ist, der eine Mehrzahl von Antennen zugeordnet ist. Diese Antennen sind jedoch nicht an einem Ort konzentriert, sondern befinden sich auch entfernt von der zentralen Einheit verteilt in dem vom Mobilfunknetz abgedeckten Gebiet. Die zentrale Recheneinheit übernimmt die Signalverarbeitung für die entfernten Antennen, was zum einen eine Kohärenz zwischen den Signalen der entfernten Antennen erlaubt, wodurch die Signalverarbeitung deutlich reduziert wird, und was es zum anderen ermöglicht, die Einheiten mit den entfernten Antennen einfach und damit kostengünstig aufzubauen.

Zur Übertragung der auszusendenden Signale von der zentralen Recheneinheit zu der jeweiligen entfernten Antenne wird eine digitale Übertragungsstrecke eingesetzt, bevorzugt eine optische Übertragungsstrecke wie beispielsweise eine Glasfaserstrecke. Da die gesamte Signalverarbeitung in der zentralen Recheneinheit erfolgen soll, muss die digitale Übertragungsstrecke in der Lage sein, Signale mit einer Trägerfrequenz zu übertragen, die der Sendefrequenz im Mobilfunksystem entspricht. Es werden daher Trägerfrequenzen für die digitale Übertragungsstrecke im Bereich von einigen Gigahertz (GHz) bis einigen hundert GHz benötigt, was mit aktueller Glasfasertechnik erzielt werden kann.

In der Druckschrift EP 3 370 352 A1 ist eine Übertragung eines Sigma-Delta modulierten Hochfrequenzsignals über eine Glasfaserstrecke beschrieben. Der Vorteil eines Sigma-Delta modulierten Signals liegt darin, dass auf der Empfangsseite lediglich ein integrierendes Filter und ein Verstärker benötigt wird, mit denen dann die Antenne unmittelbar angesteuert werden kann.

Eine derartige Anordnung würde sich somit grundsätzlich gut eignen, um in dem beschriebenen Anwendungsfall eine entfernte Antenne eines Mobilfunksystems an eine zentrale Recheneinheit anzubinden. Allerdings setzt diese Anordnung voraus, dass die Sigma-Delta Modulation an dem Signal vorgenommen wird, das von der Antenne abgestrahlt werden soll. Mit anderen Worten würde ein Sigma-Delta Wandler benötigt, der bei einem Vielfachen der Trägerfrequenz arbeitet. Demgegenüber wäre es aus technischen Gesichtspunkten und aufgrund der Kosten vorteilhaft, das Sigma-Delta modulierte Signal nicht bei der Trägerfrequenz bereitzustellen, sondern bei einer Nutzfrequenz, also einer Frequenz im zu übertragenden Basisband. Das Basisbandsignal kann dann mithilfe eines Aufwärtswandlers auf die Trägerfrequenz gebracht werden, die über die digitale Übertragungsstrecke, beispielsweise die genannte Glasfaser, übertragen wird. Auch hierbei kann das abzustrahlende Antennensignal unmittelbar und einfach aus dem übertragenen Signal durch eine Filterung, die beispielsweise durch passive Elemente oder die begrenzte Bandbreite des Leistungsverstärkers realisiert werden kann, gewonnen werden.

Ein Aufbringen von binären Signalen, z.B. also Digitalsignalen mit einer Sigma-Delta Codierung, auf eine erhöhte Trägerfrequenz kann beispielsweise durch einen digitalen Multiplexer erfolgen, der mit der Trägerfrequenz getaktet wird. Für den genannten Anwendungsfall im Mobilfunkbereich, der mit Trägerfrequenzen im Bereich von einigen bis einigen hundert Gigahertz einhergeht, sind derartige digitale Multiplexer jedoch sehr aufwendig und kostspielig. Üblicherweise können solche digitalen Multiplexer schnelle Signale schalten, die Schaltfrequenz ist jedoch nicht ausreichend, um ein Basisband in ein Übertragungsband hochzusetzen.

Es ist eine Aufgabe der vorliegenden Erfindung, ein Verfahren und eine Anordnung der eingangs genannten Art zu schaffen, mit denen binäre Basisbandsignale über eine gemeinsame digitale Übertragungsstrecke bei einer erhöhten Trägerfrequenz übertragen werden können, wobei das Verfahren bzw. die Anordnung auch im Bereich von hohen Trägerfrequenzen von mindestens einigen Gigahertz einfach und kostengünstig umsetzbar sein soll.

Diese Aufgabe wird durch ein Verfahren beziehungsweise eine Anordnung mit den Merkmalen des jeweiligen unabhängigen Anspruchs gelöst. Vorteilhafte Ausgestaltung und Weiterbildungen sind Gegenstand der abhängigen Ansprüche.

Ein erfindungsgemäßes Verfahren der eingangs genannten Art zeichnet sich dadurch aus, dass aus beiden binären Basisbandsignalen ein Summensignal und Differenzsignal gebildet werden, wobei das Summensignal und das Differenzsignal Eingängen des Quadraturmischers zugeführt werden, durch den Quadraturmischer zusammengeführt werden und auf die Trägerfrequenz aufwärts gewandelt werden, wobei das gemischte und aufwärts gewandelte Signal des Quadraturmischers über die digitale Übertragungsstrecke übertragen wird.

Quadraturmischer, auch IQ-Mischer genannt, sind analog arbeitende Mischer, die das jeweilige Eingangssignal mit einem Trägerfrequenzsignal multiplizieren - in dem einen Fall in unveränderter Form und in dem anderen Fall um 90° phasenverschoben - und die die beiden multiplizierten Signale aufsummiert an einem Ausgang bereitstellen. Derartige IQ-Mischer werden vielfach eingesetzt und sind als Standardbauteile handelsüblich auch für hohe Frequenzen kostengünstig erhältlich.

Die vorliegende Erfindung beruht auf dem Grundgedanken, dass ein derartiger IQ-Mischer vorteilhaft eingesetzt werden kann, um die binären Basisbandsignale zusammenzuführen und auf die erhöhte Trägerfrequenz aufwärts zu wandeln, wenn die binären Basisbandsignale geeignet vorverarbeitet werden. Konkret werden die binären Basisbandsignale nicht unmittelbar den Eingängen des IQ-Mischers zugeführt, sondern es wird ihre Summe auf den einen Eingang und ihre Differenz auf den anderen Eingang des IQ-Mischers geführt. Die dazu erforderliche Vorverarbeitung der Summen- beziehungsweise Differenzbildung findet bei der Frequenz der Eingangssignale, also im Basisband, statt, weswegen eine entsprechende Vorverarbeitungsstufe z.B. analog aufgebaut werden kann. Das Verfahren lässt sich somit mit einfachen und kostengünstigen Bauteilen umsetzen, ohne dass ein spezieller und bei den genannten hohen Frequenzen arbeitender digitaler Multiplexer erforderlich wäre.

Als binäre Signale werden im Rahmen der Erfindung Signale bezeichnet, die, abgesehen von Rauschanteilen, durch zwei diskrete Werte, z.B. zwei Spannungswerte, repräsentiert werden können. Als Basisband wird der Frequenzbereich eines durch das erfindungsgemäße Verfahren oder bei der erfindungsgemäßen Anordnung zu übertragenden Nutzsignals bezeichnet, der bis zu einer Grenzfrequenz reicht. Ein Basisbandsignal ist entsprechend ein Signal, dessen Frequenz innerhalb dieses Basisbands liegt.

In einer vorteilhaften Ausgestaltung des Verfahrens ist das Trägerfrequenzsignal ein Rechtecksignal, also seinerseits ein binäres Signal. Der IQ-Mischer gibt bei Ansteuerung mit dem Rechtecksignal der Trägerfrequenz in vier Zeitabschnitten einer Periode des Trägerfrequenzsignals bei abschnittsweise konstanten Eingangssignalen diskrete Werte für die Übertragungsstrecke aus. Der eigentlich analog arbeitende IQ-Mischer wird aufgrund der Ansteuerung mit dem Rechtecksignal zu einem Bauteil, das zur Einspeisung in die digitale Übertragungsstrecke geeignet ist. Wegen der gebildeten vier Zeitabschnitte pro Periode des Trägerfrequenzsignals wird bevorzugt die Trägerfrequenz mindestens 4-mal so hoch gewählt wie eine Grenzfrequenz des Basisbands.

In einer weiteren vorteilhaften Ausgestaltung des Verfahrens sind die binären Basisbandsignale Sigma-Delta modulierte Signale eines Analogsignals oder die Sigma-Delta codierte digitale Darstellung des Basisbandsignals. Bei einer derartigen Aufbereitung der Signale kann aus dem hochgesetzten digitalen Signal durch einfache Filterung ein von einer Antenne abzustrahlende Signal erzeugt werden. Das Verfahren ermöglicht so kompakte Antennenmodule, die beispielsweise an Hauswände montiert werden können, ohne einen Stellplatz für Steuerungs- und Sendeelektronik oder einen Betriebs- und Technikraum zu benötigen. Bevorzugt wird entsprechend das von der digitalen Übertragungsstrecke übertragene Signal empfangen, verstärkt und gefiltert und über eine Antenne abgestrahlt. Besonders bevorzugt wird zur Filterung ein Bandpassfilter eingesetzt.

In einer weiteren vorteilhaften Ausgestaltung des Verfahrens erfolgt die Übertragung über die digitale Übertragungsstrecke optisch, insbesondere über eine Glasfaser. Glasfasern sind kostengünstig und eine Übertragung über Glasfasern ist energieeffizient. Die zunehmende Verbreitung von Glasfasern zur Bereitstellung von Internet über Glasfasern auch an private Haushalte ermöglicht es, die Übertragung der Antennensignale über die vorhandene Datenübertragungs-Infrastruktur vorzunehmen.

Eine erfindungsgemäße Anordnung der eingangs genannten Art zeichnet sich durch eine Vorverarbeitungsstufe aus, um aus den binären Basisbandsignalen ein Summensignal und Differenzsignal zu bilden, und zeichnet sich durch einen Quadraturmischer aus, um das Summensignal und das Differenzsignal zusammenzuführen und mithilfe eines Trägerfrequenzsignals mit der Trägerfrequenz zu einem Signal aufwärts zu wandeln und das aufwärts gewandelte Signal über die digitale Übertragungsstrecke zu übertragen. Es ergeben sich die im Zusammenhang mit dem Verfahren genannten Vorteile.

Bevorzugt weist der Quadraturmischer zwei analog arbeitende Mischer und einen Phasenschieber für das Trägerfrequenzsignal auf.

In einer vorteilhaften Ausgestaltung der Anordnung weist die Vorverarbeitungsstufe Treiber und Invertierer, welche beispielsweise durch ein Nicht-Gatter realisiert werden können, sowie Widerstände auf, um das Summensignal und das Differenzsignal zu bilden. Bevorzugt sind dabei die Treiber und Invertierer Bausteine in CMOS (Complementary Metal-Oxide Semiconductor) -Technik, TTL (Transistor Transistor Logic) -Technik oder ECL (Emitter Coupled Logic) - Technik oder solche, die in einem ASIC (Application-Specific Integrated Circuit) oder in einem programmierbaren Logikbaustein zusammengefasst sind. Da die Vorverarbeitungsstufe vorteilhaft nur im Basisfrequenzband arbeitet und nicht bei der höheren Trägerfrequenz, kann sie mit einfachen, kostengünstigen und etablierten Logikbausteinen aufgebaut werden.

In einer weiteren vorteilhaften Ausgestaltung der Anordnung umfasst die digitale Übertragungsstrecke eine Glasfaser. Wie bei dem Verfahren bereits erwähnt, ist die Übertragung über Glasfaser im Hinblick auf Kosten, Energieeffizienz und die Möglichkeit, bereits bestehende Daten-Infrastruktur zu nutzen, vorteilhaft.

Die Erfindung wird nachfolgend anhand eines Ausführungsbeispiels mithilfe von Figuren näher erläutert. Die Figuren zeigen:

Fig. 1　ein Blockschaltbild einer Übertragungsanordnung mit einer Zentraleinheit und einer Mehrzahl von entfernt angeordneten Antennenmodulen;

Fig. 2　ein detaillierteres Blockschaltbild, das einen Teil der Zentraleinheit aus Figur 1 und ein Antennenmodul gemäß Figur 1 wiedergibt;

Fig. 3　ein in der Übertragungsanordnung der Figur 2 eingesetzter Aufwärtswandler in einem detaillierteren Blockschaltbild;

Fig. 4　eine Tabelle zur Erläuterung verschiedener Signalzustände; und

Fig. 5　ein beispielhaftes Blockschaltbild einer Vorverarbeitungsstufe des Aufwärtswandlers gemäß Figur 3.

In allen Figuren kennzeichnen gleiche Bezugszeichen gleiche oder gleichwirkende Elemente. Aus Gründen der Übersichtlichkeit ist nicht in jeder Figur jedes Element mit einem Bezugszeichen versehen.

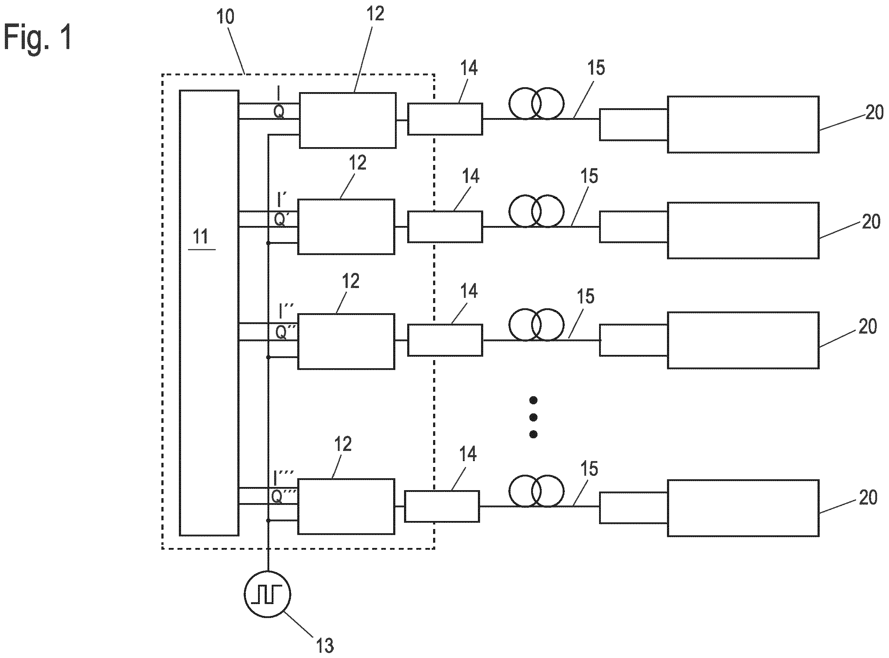

Figur 1 zeigt zunächst einen möglichen Anwendungsfall für ein erfindungsgemäßes Verfahren bzw. eine erfindungsgemäße Anordnung, bei dem eine Mehrzahl von Antennenmodulen 20 von einer Zentraleinheit 10 betrieben wird. Die Antennenmodule 20 sind dabei jeweils über eine Glasfaser 15 mit der Zentraleinheit 10 verbunden. Die gezeigte Anordnung kann beispielsweise im Rahmen eines Mobilfunknetzes mit einer zellfreien Struktur und verteilten Antennen eingesetzt werden.

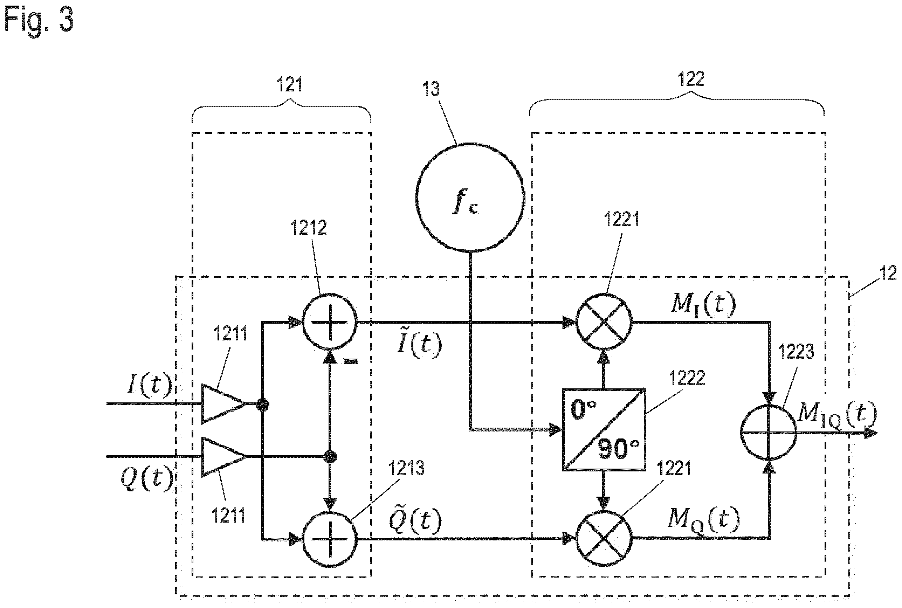

Die Zentraleinheit 10 umfasst eine Datenquelle 11, die an die Antennenmodule 20 zu übertragende Daten bereitstellt. Für jedes Antennenmodul 20 sind vorliegend zwei digitale Datenströme vorgesehen, die in der Figur mit I und Q beziehungsweise I', Q', I", Q" und I‴, Q‴ bezeichnet sind. Die Anzahl der hier vier dargestellten Übertragungszweige ist rein beispielhaft. Die gezeigten digitalen Datenströme I, Q stellen binäre Basisbandsignale dar, in denen zu übertragende Informationen z.B. quadraturamplitudenmoduliert enthalten sind, wobei Amplituden- und/oder Phasenumtastung für die zugrundeliegenden digitalen Daten eingesetzt werden kann. Die binären Basisbandsignale geben bevorzugt ein zu übertragendes Analogsignal in Form einer Sigma-Delta modulierten Repräsentation wieder. Bei dieser Art der Umwandlung eines Analogsignals in ein Digitalsignal kann das Analogsignal im Antennenmodul 20 durch einfache integrierende Filterung wieder rekonstruiert werden. Des Weiteren übernimmt der Sigma-Delta Wandler in Verbindung mit dem Bandpassfilter an einer Antenne des Antennenmoduls (vgl. Filter 23 und Antenne 24 in Figur 3) die Rolle eines Digital-zu-Analog Wandlers.

Die jeweiligen binären Basisbandsignale I und Q werden zusammen mit einem Trägerfrequenzsignal, das im gezeigten Beispiel von einem lokalen Oszillator 13 erzeugt wird, einem Aufwärtswandler 12 zugeführt. Es kann auch ein zugeführter Referenztakt verwendet werden, 13 übernimmt dann die Funktion eines Treibers oder Referenztaktregenerators. Der jeweilige Aufwärtswandler 12 stellt an einem Ausgang ein Signal bei der Trägerfrequenz des lokalen Oszillators 13 bereit, bei dem die Informationen der binären Basisbandsignale auf die Trägerfrequenz des lokalen Oszillators hochgewandelt sind.

An dem Ausgang des jeweiligen Aufwärtswandlers 12 wird ein Binärsignal ausgegeben, das einem Glasfasersender 14 zugeführt wird, der dieses Signal über die jeweilige Glasfaser 15 an das entsprechende Antennenmodul 20 überträgt.

Bei dem beschriebenen System ist zunächst nur eine Übertragung von Daten beziehungsweise Signalen von der Zentraleinheit 10 zu den Antennenmodulen 20 angegeben. Eine derartige Anordnung ist beispielsweise im Rahmen eines Testsystems für ein zellfreies Mobilfunksystem mit verteilten Antennen ausreichend. In einem realen Mobilfunksystem würde jeweils auch noch ein Rückkanal vom Antennenmodul 20 zur Zentraleinheit 10 umgesetzt sein.

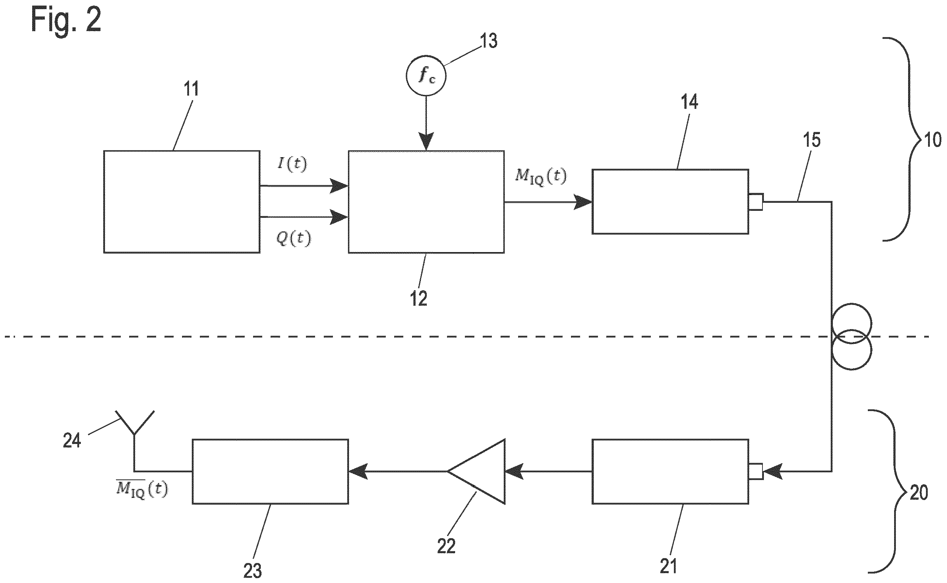

In Figur 2 ist die Anordnung aus Figur 1 für einen der Übertragungszweige zu einem der Antennenmodule 20 detaillierter wiederum in einem Blockschaltbild dargestellt.

Auf der Senderseite der Zentraleinheit 10 ist an den Eingängen des Aufwärtswandlers 12 durch die Notation I(t), Q(t) jeweils eine zeitabhängige Funktion dargestellt. Ausgegeben wird von dem Aufwärtswandler 12 ein ebenfalls zeitabhängiges Mischsignal $M_{IQ}(t)$. Das von dem lokalen Oszillator 13 bereitgestellte Trägersignal ist ein Rechtecksignal mit einer Trägerfrequenz $f_c$ (c: "carrier"), die mindestens um den Faktor 4, in der Regel aber um einen vielfach größeren Faktor, größer ist als eine Grenzfrequenz der Basisbandsignale I(t), Q(t). Das Mischsignal $M_{IQ}(t)$ ist ein Signal, bei dem die Basisbandsignale I(t), Q(t) auf die Trägerfrequenz $f_c$ aufmoduliert sind.

Darüber hinaus weist die Sendeseite der Zentraleinheit 10 noch den Glasfasersender 14 auf, der Licht, beispielsweise Infrarotlicht, das von einer Leuchtdiode oder einem Halbleiterlaser im Takt des Mischsignals $M_{IQ}(t)$ erzeugt wird, in die Glasfaser 15 einspeist. Alternativ kann der Glasfasersender 14 auch eine kontinuierlich leuchtende Lichtquelle umfassen, deren Licht durch einen elektrooptischen Modulator mit dem Mischsignal $M_{IQ}(t)$ moduliert wird. Der Glasfasersender 14 und die Glasfaser 15, in die der Glasfasersender 14 einspeist, können dabei handelsübliche Komponenten der Kommunikationstechnik sein.

Auf der Empfangsseite, die hier durch das Antennenmodul 20 repräsentiert wird, speist die Glasfaser 15 in einen Glasfaserempfänger 21 ein, der eine Fotodiode oder ein vergleichbares fotoempfindliches Element aufweist, das das empfangene Lichtsignal wieder in elektrische Signale umwandelt. An den Glasfaserempfänger 21 schließt sich ein Verstärker 22 sowie ein Filter 23 an. Das Filter 23, vorzugsweise ein Bandpassfilter, gibt an seinem Ausgang das bandpassgefilterte Mischsignal $M_{IQ}(t)$ aus. Bedingt durch die Natur der von der Datenquelle 11 bereitgestellten binären Basisbandsignale I(t) und Q(t) als Sigma-Delta modulierte Signale entspricht die Bandbegrenzung, die vom Filter 23 vorgenommen wird, einer Demodulation dieser Sigma-Delta modulierten Signale, so dass an dem Ausgang des Filters 23 unmittelbar ein beispielsweise quadraturamplitudenmoduliertes Antennensignal im Bereich der Trägerfrequenz $f_c$ vorliegt, das gesendet werden kann.

Figur 3 zeigt den erfindungsgemäßen Aufbau des Aufwärtswandlers 12 detaillierter. Dieser setzt sich zusammen aus einer Vorverarbeitungsstufe 121, an die sich ein (handelsüblicher) IQ-Mischer 122 anschließt.

Die Vorverarbeitungsstufe 121 weist zwei Treiber 1211 auf, die die Eingangssignale I(t) und Q(t) auf zwei nachfolgende Bausteine weiterleiten, konkret einen Subtrahierer 1212 und einen Addierer 1213. Im Subtrahierer 1212 wird das Signal Q(t) vom Eingangssignal I(t) abgezogen und stellt ein modifiziertes Ausgangssignal $\tilde{I}(t)$ der Vorverarbeitungsstufe 121 zur Verfügung. Das modifizierte Ausgangssignal $\tilde{I}$ wird nachfolgend auch als Differenzsignal $\tilde{I}$ bezeichnet.

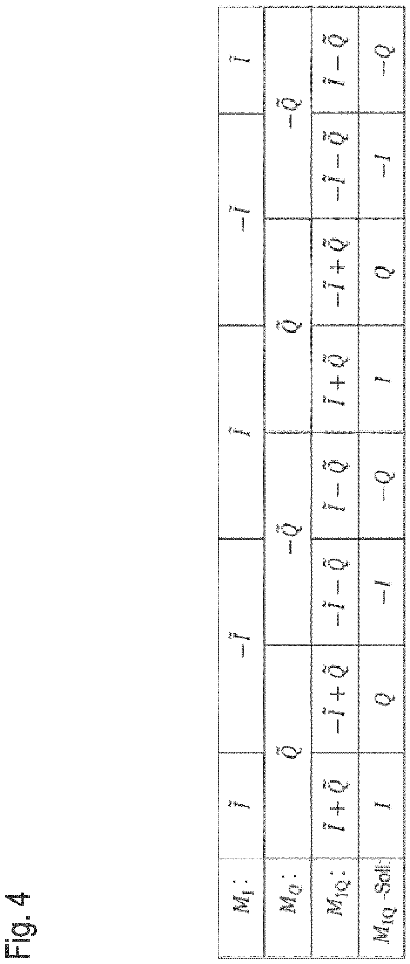

Der Addierer 1213 addiert die beiden Eingangssignale I(t) und Q(t) und stellt an seinem Ausgang ein modifiziertes Ausgangssignal $\tilde{Q}(t)$ dar. Das modifizierte Ausgangssignal $\tilde{Q}$ wird nachfolgend auch als Summensignal $\tilde{Q}$ bezeichnet. Der Grund für diese Art der Vorverarbeitung der Signale wird nachfolgend im Zusammenhang mit Figur 4 noch näher erläutert.

Die modifizierten Signale $\tilde{I}(t)$ und $\tilde{Q}(t)$ werden dem IQ-Mischer 122 zugeführt. Dieser weist zwei Multiplizierer 1221 auf, denen jeweils eines der beiden genannten modifizierten Signale $\tilde{I}(t)$ und $\tilde{Q}(t)$ zugeführt wird, das dann mit den beispielsweise 90° phasenverschobenen Ausgangssignalen eines Phasenschiebers 1222 multipliziert wird, was in entsprechenden multiplizierten Signale $M_I(t)$ und $M_Q(t)$ resultiert. Der Ausgang des IQ-Mischers 122 wird dabei von einem Addierer 1223 gebildet, der die multiplizierten Signale $M_I(t)$ und $M_Q(t)$ zum Gesamtsignal $M_{IQ}(t)$ addiert.

Der Phasenschieber 1222 wird vom lokalen Oszillator 13 mit dem Rechtecksignal der Trägerfrequenz $f_c$ angesteuert, das nachfolgend auch als Trägerfrequenzsignal bezeichnet wird. Die beiden genannten Ausgänge des Phasenschiebers 1222 geben das Signal des lokalen Oszillators 13 einmal ohne Phasenverschiebung und einmal mit einer 90° Phasenverschiebung aus.

Der handelsübliche IQ-Mischer 122 ist ein Analogbauteil, das sowohl an den Signaleingängen als auch am Signalausgang und auch am Eingang für die Trägerfrequenz analoge Signale verarbeiten kann. Da das Trägerfrequenzsignal vom lokalen Oszillator 13 als Rechtecksignal, also als Signal mit zwei Zuständen bereitgestellt wird, führt der Phasenschieber 1222 dazu, dass in einer Periode des Trägerfrequenzsignals z.B. genau vier diskrete Kombinationen an den Ausgängen des Phasenschiebers 1222 nacheinander durchlaufen werden. Der eigentlich analog arbeitende IQ-Mischer 122 wird aufgrund der Ansteuerung mit dem Rechtecksignal der Trägerfrequenz zu einem Bauteil, das beispielsweise in vier Zeitabschnitten einer Periode des Trägerfrequenzsignals bei der Annahme abschnittsweise konstanter Eingangssignale $\tilde{I}(t)$ und $\tilde{Q}(t)$ beispielsweise vier verschiedene und über den jeweiligen Zeitabschnitt konstante diskrete Werte ausgibt.

In der Tabelle der Figur 4 sind beispielhaft für zwei Periodenlängen des Trägerfrequenzsignals die Schaltzustände des IQ-Mischers 122 angegeben. Es wird dabei von einem konstanten Eingangssignal $\tilde{I}(t)$ und $\tilde{Q}(t)$ ausgegangen. In der ersten Spalte ist die Bezeichnung des jeweiligen Signals angegeben. In den dann folgenden acht Spalten, von denen teilweise jeweils zwei zusammengefasst sind, wenn sie den gleichen Wert aufweisen, sind die verschiedenen Werte dargestellt, die die genannten Signale innerhalb der beiden aufeinanderfolgenden Perioden des Trägerfrequenzsignals einnehmen können.

Es zeigt sich, dass am Ausgang des IQ-Mischers 122, also bei dem Signal $M_{IQ}(t)$, in jedem Zeitabschnitt eine Mischung der Eingangssignale $\tilde{I}(t)$ und $\tilde{Q}(t)$ vorliegt. In allen vier Zeitabschnitten einer Periode sind in diesem Beispiel dabei jeweils beide Eingangskomponenten im Ausgangssignal enthalten, mal mit positiven, mal mit negativen Vorzeichen.

Im Hinblick auf die nicht-modifizierten Basisbandsignale I(t) und Q(t), die an dem Aufwärtswandler 12 anliegen, ist jedoch gewünscht, dass in jeder Zeitperiode nur einer der beiden Anteile, also entweder I(t) oder Q(t), vorhanden ist. Nur dann können die Signale voneinander getrennt übertragen werden. Der jeweilige Zustand im Hinblick auf die Basisbandsignale I(t) und Q(t) ist in der letzten Zeile der Tabelle als gewünschter Wert angegeben. Aus diesen gewünschten Werten lassen sich Gleichungen ableiten, wie $\tilde{I}(t)$ und $\tilde{Q}(t)$ in Abhängigkeit von I(t) oder Q(t) gewählt werden müssen, damit am Ausgang des IQ-Mischers 122 in den verschiedenen Zeitabschnitten die gewünschten Signale gemäß der letzten Spalte der Tabelle in Figur 4 tatsächlich anliegen.

Es ergibt sich für das vorgegebene Beispiel folgendes Gleichungssystem (Gl. 1):

$$I = \tilde{I} + \tilde{Q}$$

$$Q = -\tilde{I} + \tilde{Q}$$

$$-I = -\tilde{I} - \tilde{Q}$$

$$-Q = \tilde{I} - \tilde{Q}$$

Aus Gl. 1 ergeben sich die folgenden Bedingun-

gen für $\tilde{I}$ und $\tilde{Q}$ in Abhängigkeit von I und Q (Gl. 2):

$$\tilde{I} = \frac{1}{2}(I - Q)$$

$$\tilde{Q} = \frac{1}{2}(I + Q)$$

Genau diese Funktionsbedingungen gemäß Gl. 2 werden durch die Vorverarbeitung der Eingangssignale I(t) und Q(t) in der Vorverarbeitungsstufe 121 umgesetzt.

Mit anderen Worten wird durch die Art der Vorverarbeitung der zu sendenden Signale I(t) und Q(t) im Basisband erreicht, dass der eigentlich analog arbeitende IQ-Mischer 122 für die zugeführten Binärsignale eine Multiplexfunktion annimmt, in der seriell nacheinander innerhalb eines Taktes die Ausgangswerte +I, +Q, -I, -Q durchgeschaltet werden. Die Vorverarbeitung im Frequenzbereich des Basisbands ermöglicht es damit, den preisgünstigen und einfach aufgebauten analogen IQ-Mischer 122 einzusetzen und eine Multiplexfunktion für die gegebenenfalls sehr viel höhere Trägerfrequenz $f_c$ auszuüben.

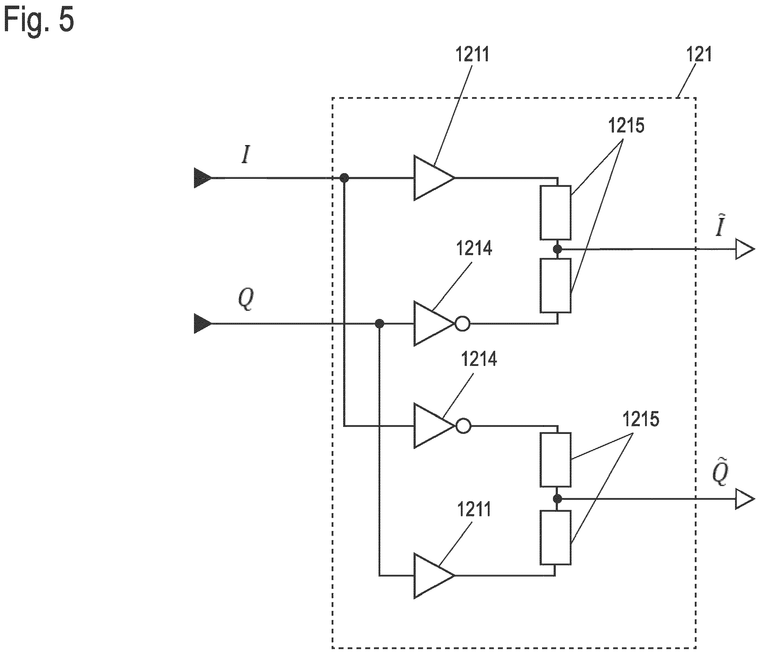

Figur 5 zeigt einen möglichen Aufbau der Vorverarbeitungsstufe 121. Bei diesem Aufbau werden die Eingangssignale I und Q jeweils zwei Treibern 1211 zugeordnet, deren Ausgänge über zwei Widerstände 1215 mit beispielsweise gleichem Widerstandswert zusammen auf den Ausgang für das modifizierte Signal $\tilde{Q}$ geleitet werden. Auf diese Weise werden die beiden Signale I und Q zum Ausgangssignal $\tilde{Q}$ addiert.

Weiter wird das Eingangssignal I beispielsweise einem weiteren Treiber 1211 zugeleitet und das Ausgangssignal Q einem Invertierer 1214. Der Invertierer 1214 ist ein invertierender Treiber, der die gleiche Ausgangsimpedanz wie der Treiber 1211 aufweist. Der Ausgang des Treibers 1211 und des Invertierers 1214 werden wiederum über zwei gleichgroße Widerstände 1215 addiert, um das modifizierte Signal $\tilde{I}$ zu bilden. Da die Signalvorverarbeitung im Basisband erfolgt, kann die gezeigte Anordnung beispielsweise relativ einfach und kostengünstig mithilfe von integrierten Schaltkreisen für die Treiber 1211 und den Invertierer 1214 auf der Basis von CMOS-, TTL- und/oder ECL-Bausteinen erfolgen, deren Signaldurchlauf- und Schaltzeiten nur für die begrenzte Bandbreite des Basisbandsignals geeignet sein müssen. Ebenfalls können ASICs oder programmierbare Logikbausteine eingesetzt werden.

**Bezugszeichen**

10 Zentraleinheit
11 Datenquelle

12 Aufwärtswandler
    121 Vorverarbeitungsstufe
    1211 Treiber
    1212 Subtrahierer
    1213 Addierer
    1214 Invertierer
    1215 Widerstand
    122 IQ-Mischer
    1221 Multiplizierer
    1222 Phasenschieber
    1223 Addierer
13 Oszillator
14 Glasfasersender
15 Glasfaser

20 Antennenmodul
21 Glasfaserempfänger
22 Verstärker
23 Filter
24 Antenne

**Patentansprüche**

1. Verfahren zur Übertragung von zwei binären Basisbandsignalen (I, Q) über eine gemeinsame digitale Übertragungsstrecke bei einer gegenüber einer Grenzfrequenz der Basisbandsignale erhöhten Trägerfrequenz ($f_c$), **dadurch gekennzeichnet, dass** aus den binären Basisbandsignalen (I, Q) ein Summensignal ($\tilde{Q}$) und Differenzsignal ($\tilde{I}$) gebildet werden, wobei das Summensignal ($\tilde{Q}$) und das Differenzsignal ($\tilde{I}$) Eingängen eines Quadraturmischers (122) zugeführt werden, sie durch den Quadraturmischer (122) zusammengeführt werden und mithilfe eines Trägerfrequenzsignals mit der Trägerfrequenz ($f_c$) zu einem Signal ($M_{IQ}$) aufwärts gewandelt werden, wobei das aufwärts gewandelte Signal ($M_{IQ}$) über die digitale Übertragungsstrecke übertragen wird.

2. Verfahren nach Anspruch 1, bei dem das Trägerfrequenzsignal ein Rechtecksignal ist.

3. Verfahren nach Anspruch 1 oder 2, bei dem die Trägerfrequenz ($f_c$) mindestens 4-mal so hoch ist wie eine Grenzfrequenz des Basisbands.

4. Verfahren nach einem der Ansprüche 1 bis 3, bei dem die binären Basisbandsignale (I, Q) Sigma-Delta modulierte Signale eines Analogsignals oder die Sigma-Delta codierte digitale Darstellung des Basisbandsignals sind.

5. Verfahren nach Anspruch 4, bei dem das über die digitale Übertragungsstrecke übertragene Signal empfangen, verstärkt und gefiltert wird und über eine Antenne abgestrahlt wird.

6.  Verfahren nach Anspruch 5, bei dem zur Filterung ein Bandpassfilter eingesetzt wird.

7.  Verfahren nach einem der Ansprüche 1 bis 6, bei dem die Übertragung über die digitale Übertragungsstrecke optisch erfolgt.

8.  Verfahren nach Anspruch 7, bei dem die Übertragung über eine Glasfaser (15) erfolgt.

9.  Anordnung zur Übertragung von zwei binären Basisbandsignalen (I, Q) über eine gemeinsame digitale Übertragungsstrecke bei einer gegenüber dem Basisband erhöhten Trägerfrequenz ($f_c$), **gekennzeichnet durch** eine Vorverarbeitungsstufe (121), um aus den binären Basisbandsignalen (I, Q) ein Summensignal ($\tilde{Q}$) und Differenzsignal ($\tilde{I}$) zu bilden, und einem Quadraturmischer (122), um das Summensignal ($\tilde{Q}$) und das Differenzsignal ($\tilde{I}$) zusammenzuführen werden und mithilfe eines Trägerfrequenzsignals mit der Trägerfrequenz ($f_c$) zu einem Signal ($M_{IQ}$) aufwärts zu wandeln und das aufwärts gewandelte Signal ($M_{IQ}$) über die digitale Übertragungsstrecke zu übertragen.

10. Anordnung nach Anspruch 9, bei der der Quadraturmischer (122) zwei analog arbeitenden Mischer aufweist.

11. Anordnung nach Anspruch 9 oder 10, bei der der Quadraturmischer (122) einen Phasenschieber (1222) für das Trägerfrequenzsignal aufweist.

12. Anordnung nach einem der Ansprüche 9 bis 11, bei der die Vorverarbeitungsstufe (121) Treiber (1211) und Invertierer (1421) sowie Widerstände (1215) aufweist, um das Summensignal ($\tilde{Q}$) und das Differenzsignal ($\tilde{I}$) zu bilden.

13. Anordnung nach Anspruch 12, bei der die Treiber (1211) und Invertierer (1421) Bausteine in CMOS-Technik, TTL-Technik oder ECL-Technik sind oder in einem ASIC oder in einem programmierbaren Logikbaustein zusammengefasst sind.

14. Anordnung nach einem der Ansprüche 9 bis 13, bei der die digitale Übertragungsstrecke eine Glasfaser (15) umfasst.

Fig. 1

## Fig. 2

EP 4 679 731 A1

Fig. 3

EP 4 679 731 A1

# Fig. 4

| $M_I$: | $\tilde{I}$ | | $-\tilde{I}$ | | $\tilde{I}$ | | $-\tilde{I}$ | $\tilde{I}$ |
|---|---|---|---|---|---|---|---|---|
| $M_Q$: | $\tilde{Q}$ | | $-\tilde{Q}$ | | $\tilde{Q}$ | | $-\tilde{Q}$ | |
| $M_{IQ}$: | $\tilde{I}+\tilde{Q}$ | $-\tilde{I}+\tilde{Q}$ | $-\tilde{I}-\tilde{Q}$ | $\tilde{I}-\tilde{Q}$ | $\tilde{I}+\tilde{Q}$ | $-\tilde{I}+\tilde{Q}$ | $-\tilde{I}-\tilde{Q}$ | $\tilde{I}-\tilde{Q}$ |
| $M_{IQ}$-Soll: | $I$ | $Q$ | $-I$ | $-Q$ | $I$ | $Q$ | $-I$ | $-Q$ |

Fig. 5

EP 4 679 731 A1

Europäisches
Patentamt

European
Patent Office

Office européen
des brevets

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | US 2008/055014 A1 (TSFATY YOSSI [IL]) 6. März 2008 (2008-03-06) * das ganze Dokument * ----- | 1-14 | INV. H04B10/2575 H03C3/40 H03D7/00 |
| A | US 2004/037369 A1 (MATSUURA TORU [JP] ET AL) 26. Februar 2004 (2004-02-26) * Absatz [0163] - Absatz [0172]; Abbildung 1 * ----- | 1-14 | H04L27/227 |
| A | EP 0 795 983 A1 (ITT IND GMBH DEUTSCHE [DE]) 17. September 1997 (1997-09-17) * das ganze Dokument * ----- | 1-14 | |
| A | DE 601 24 451 T2 (MATSUSHITA ELECTRIC IND CO LTD [JP]) 15. März 2007 (2007-03-15) * das ganze Dokument * ----- | 1-14 | |

RECHERCHIERTE
SACHGEBIETE (IPC)

H04B
H03D
H04L
H03C

Der vorliegende Recherchenbericht wurde für alle Patentansprüche erstellt

| Recherchenort | Abschlußdatum der Recherche | Prüfer |
|---|---|---|
| München | 22. November 2024 | Gäde, Sebastian |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.......................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 18 8379

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-11-2024

| Im Recherchenbericht angeführtes Patentdokument | Datum der Veröffentlichung | Mitglied(er) der Patentfamilie | Datum der Veröffentlichung |
|---|---|---|---|
| US 2008055014 A1 | 06-03-2008 | KEINE | |
| US 2004037369 A1 | 26-02-2004 | CN 1469552 A<br>US 2004037369 A1 | 21-01-2004<br>26-02-2004 |
| EP 0795983 A1 | 17-09-1997 | EP 0795983 A1<br>US 5923223 A | 17-09-1997<br>13-07-1999 |
| DE 60124451 T2 | 15-03-2007 | DE 60124451 T2<br>EP 1161044 A2<br>US 2001050962 A1 | 15-03-2007<br>05-12-2001<br>13-12-2001 |

EPO FORM P0461

Für nähere Einzelheiten zu diesem Anhang : siehe Amtsblatt des Europäischen Patentamts, Nr.12/82

IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3370352 A1